# EUROPEAN PATENT APPLICATION

(11) **EP 1 788 440 A2**
(43) Date of publication of application: **23.05.2007**
(21) Application number: 06121183.5
(22) Date of filing: 25.09.2006
(51) Int. Cl.: G03F 7/11

(54) **Barrier film material and pattern formation method using the same**

(30) Priority: 17.11.2005 JP 2005333305
(71) Applicant: MATSUSHITA ELECTRIC INDUSTRIAL CO., LTD., Kadoma-shi, Osaka 571-8501 (JP)
(72) Inventor: Endo, Masayuki, Chuo-ku Osaka Osaka 540-6319 (JP); Sasago, Masaru, Chuo-ku Osaka Osaka 540-6319 (JP)
(74) Representative: Zimmer, Franz-Josef

(57) **Abstract**

In a pattern formation method, a barrier film including a polymer and a cross-linking agent for thermally causing a cross-linking reaction of the polymer is formed on a resist film formed on a substrate. Subsequently, the barrier film is annealed for cross-linking the polymer, and pattern exposure is performed by selectively irradiating the resist film with exposing light through the barrier film with a liquid provided on the barrier film. Then, after removing the barrier film, the resist film is developed after the pattern exposure. Thus, a resist pattern made of the resist film is formed.

## Description

### CROSS-REFERENCE TO RELATED APLICATIONS

This application claims priority under 35 U.S.C. §119 on Patent Application No. 2005-333305 filed in Japan on November 17, 2005, the entire contents of which are hereby incorporated by reference.

### BACKGROUND OF THE INVENTION

The present invention relates to a material for a barrier film formed on a resist film for use in immersion lithography in fabrication process or the like for semiconductor devices and a pattern formation method using the same.

In accordance with the increased degree of integration of semiconductor integrated circuits and downsizing of semiconductor devices, there are increasing demands for further rapid development of lithography technique. Currently, pattern formation is carried out through photolithography using exposing light of a mercury lamp, KrF excimer laser, ArF excimer laser or the like, and use of F₂ laser lasing at a shorter wavelength is being examined. However, since there remain a large number of problems in exposure systems and resist materials, photolithography using exposing light of a shorter wavelength has not been put to practical use.

In these circumstances, immersion lithography has been recently proposed for realizing further refinement of patterns by using conventional exposing light (for example, see M. Switkes and M. Rothschild, "Immersion lithography at 157 nm", J. Vac. Sci. Technol., Vol. B19, p. 2353 (2001)).

In the immersion lithography, a region in an exposure system sandwiched between a projection lens and a resist film formed on a wafer is filled with a liquid having a refractive index **n** (whereas n > 1) and therefore, the NA (numerical aperture) of the exposure system has a value **n·NA**. As a result, the resolution of the resist film can be improved.

Also, in the immersion lithography, use of an acidic solution as an immersion liquid has been recently proposed for further improving the refractive index (see, for example, B. W. Smith, A. Bourov, Y. Fan, L. Zavyalova, N. Lafferty, F. Cropanese, "Approaching the numerical aperture of water - Immersion Lithography at 193 nm", Proc. SPIE, Vol. 5377, p. 273 (2004)).

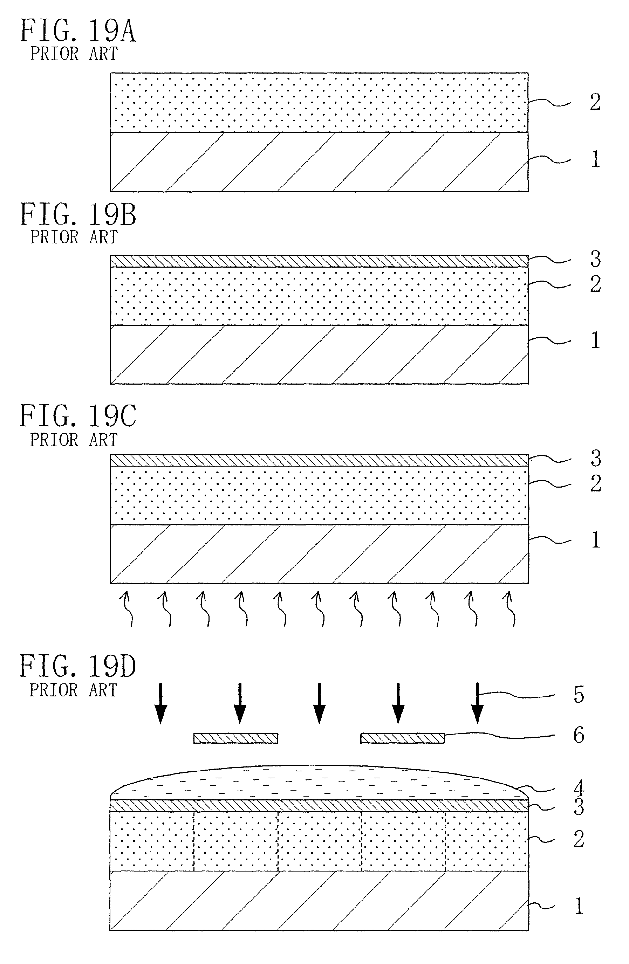

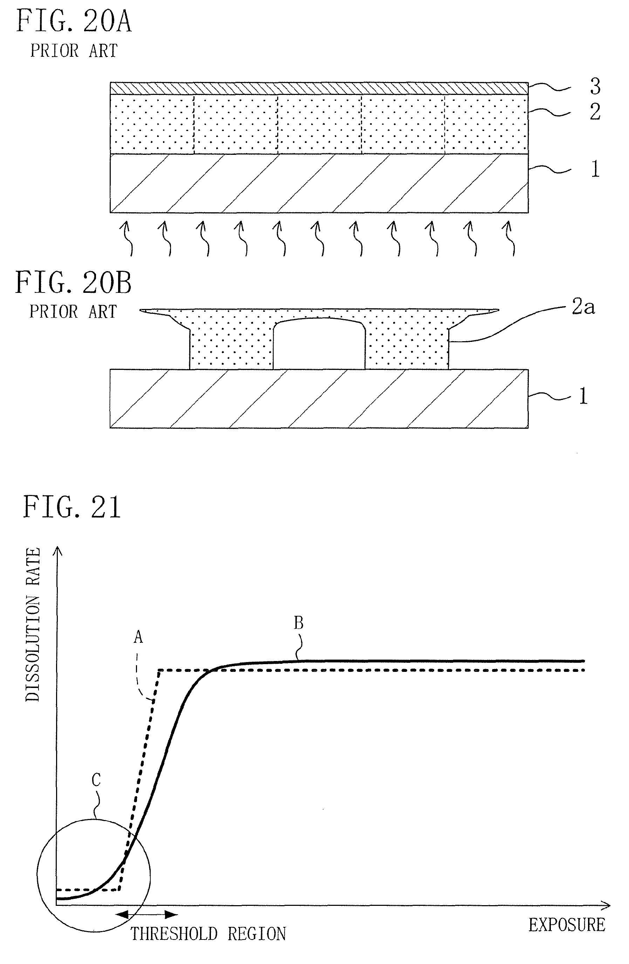

Now, a conventional pattern formation method employing the immersion lithography will be described with reference to FIGS. **19A** through **19D, 20A** and **20B.**

First, a positive chemically amplified resist material having the following composition is prepared:

| | |
|---|---|
| Base polymer: poly((norbornene-5-methylene-t-butylcarboxylate) (50 mol%) - (maleic anhydride) (50 mol%)) | 2 g |
| Acid generator: triphenylsulfonium trifluoromethane sulfonate | 0.05 g |
| Quencher: triethanolamine | 0.002 g |
| Solvent: propylene glycol monomethyl ether acetate | 20 g |

Next, as shown in FIG. **19A,** the aforementioned chemically amplified resist material is applied on a substrate **1** so as to form a resist film **2** with a thickness of 0.35 µm.

Then, as shown in FIG. **19B,** by using a barrier film material having the following composition, a barrier film **3** having a thickness of 50 nm is formed on the resist film **2** by, for example, spin coating:

| | |
|---|---|
| Base polymer: polyvinyl hexafluoroisopropyl alcohol | 1 g |
| Solvent: n-butyl alcohol | 20g |

Next, as shown in FIG. **19C,** the resultant barrier film **3** is annealed with a hot plate at a temperature of 110°C for 60 seconds.

Then, as shown in FIG. **19D**, with an immersion liquid **4** of water provided on the barrier film **3,** pattern exposure is carried out by irradiating the resist film **2** through the liquid **4** and the barrier film **3** with exposing light **5** of ArF excimer laser with NA of 0.68 having passed through a mask **6.**

After the pattern exposure, as shown in FIG. **20A,** the resist film **2** is baked with a hot plate at a temperature of 105°C for 60 seconds, and the resultant resist film is developed with a 2.38 wt% tetramethylammonium hydroxide developer. In this manner, a resist pattern **2a** made of an unexposed portion of the resist film **2** is formed as shown in FIG. **20B.**

However, as shown in FIG. **20B,** the resist pattern **2a** obtained by the conventional pattern formation method is in a defective shape.

The present inventors have variously examined the reason why the resist pattern formed by the conventional immersion lithography is in a defective shape, resulting in finding the following: Since the immersion liquid **4** permeates into the resist film **2** through the barrier film **3** formed on the resist film **2** for protecting it from the immersion liquid **4,** a water mark defect is caused in the resist film **2** after the pattern exposure. In FIG. **20B,** the acid generator included in the resist film **2** is extracted into the liquid **4** due to a water mark defect caused in the resist film **2,** and hence, the chemical amplification cannot be sufficiently caused through the pattern exposure and the post exposure bake. As a result, a bridge defect is caused.

When the resist pattern in such a defective shape is used for etching a target film, the resultant pattern of the target film is also in a defective shape, which disadvantageously lowers the productivity and the yield in the fabrication process for semiconductor devices.

### SUMMARY OF THE INVENTION

In consideration of the aforementioned conventional problem, an object of the invention is forming a fine resist pattern in a good shape by preventing an immersion liquid from permeating into a resist film through a barrier film formed for protecting the resist film from the immersion liquid.

The present inventors have found the following: When a polymer itself included in a barrier film used for protecting a resist film is thermally crosslinked, when the surface of a barrier film is subjected to a water-repellent treatment with fluorine plasma or when a water-repellent or waterproof film is formed on a barrier film, an immersion liquid does not permeate into the barrier film, and hence, a water mark defect is prevented from being caused in the resist film. This is probably because, in either case, the barrier film can attain a surface state for strongly repelling a liquid or preventing permeation of a liquid.

Specifically, the barrier film material of this invention is for use in forming a barrier film between a resist film and an immersion liquid when exposure of the resist film is performed with the immersion liquid provided above the resist film, and includes a polymer and a cross-linking agent for thermally causing a cross-linking reaction of the polymer.

According to the barrier film material of this invention, when a barrier film made of the present barrier film material is formed on a resist film and the resultant barrier film is annealed for causing the cross-linking reaction of the polymer, the permeability of the immersion liquid is largely lowered in the polymer cross-linked in the barrier film. Therefore, no water mark defect is caused in the resist film covered with the barrier film including the cross-linked polymer, and hence deterioration of the resist film otherwise caused by the liquid can be prevented. As a result, a fine pattern can be formed in a good shape.

In the barrier film material of the invention, the cross-linking agent may include a melamine compound or an epoxy compound.

In the barrier film material of the invention, the polymer may be polyvinyl alcohol, polyacrylic acid or polyvinyl hexafluoroisopropyl alcohol.

The first pattern formation method of this invention includes the steps of forming a resist film on a substrate; forming, on the resist film, a barrier film including a polymer and a cross-linking agent for thermally causing a cross-linking reaction of the polymer; annealing the barrier film for cross-linking the polymer by the cross-linking agent; performing pattern exposure by selectively irradiating the resist film through the barrier film with exposing light with a liquid provided on the barrier film; removing the barrier film; and forming a resist pattern made of the resist film by developing the resist film after removing the barrier film and after the pattern exposure.

In the first pattern formation method, the barrier film including the polymer and the cross-linking agent for thermally causing a cross-linking reaction of the polymer is formed on the resist film and then the barrier film is annealed to cross-link the polymer by using the cross-linking agent. Therefore, the permeability of the immersion liquid is largely lowered in the polymer cross-linked in the barrier film. Accordingly, no water mark defect is caused in the resist film covered with the barrier film including the cross-linked polymer, and hence deterioration of the resist film otherwise caused by the liquid can be prevented. As a result, a fine pattern can be formed in a good shape.

In the first pattern formation method of the invention, the cross-linking agent may include a melamine compound or an epoxy compound.

In the first pattern formation method of the invention, the polymer may be polyvinyl alcohol, polyacrylic acid or polyvinyl hexafluoroisopropyl alcohol.

The second pattern formation method of this invention includes the steps of forming a resist film on a substrate; forming a barrier film on the resist film; performing a water-repellent treatment for providing a water-repellent property to a surface of the barrier film; performing pattern exposure by selectively irradiating the resist film through the barrier film with exposing light with a liquid provided on the barrier film having been subjected to the water-repellent treatment; removing the barrier film; and forming a resist pattern made of the resist film by developing the resist film after removing the barrier film and after the pattern exposure.

In the second pattern formation method, the barrier film is subjected to the water-repellent treatment for providing a water-repellent property to the surface of the barrier film, and hence, the permeability of the immersion liquid is largely lowered in the barrier film having been subjected to the water-repellent treatment. Therefore, no water mark defect is caused in the resist film covered with the barrier film having been subjected to the water-repellent treatment, and hence deterioration of the resist film otherwise caused by the liquid can be prevented. As a result, a fine pattern can be formed in a good shape.

In the second pattern formation method, the barrier film is preferably exposed to plasma including fluorine in the step of performing a water-repellent treatment.

The third pattern formation method of this invention includes the steps of forming a resist film on a substrate; forming a barrier film on the resist film; forming a water-repellent film having a water-repellent property on the barrier film; performing pattern exposure by selectively irradiating the resist film through the water-repellent film and the barrier film with exposing light with a liquid provided on the water-repellent film; removing the water-repellent film; and removing the barrier film and forming a resist pattern made of the resist film by developing the resist film after removing the water-repellent film and after the pattern exposure.

The fourth pattern formation method of this invention includes the steps of forming a resist film on a substrate; forming a barrier film on the resist film; forming a water-repellent film having a water-repellent property on the barrier film; performing pattern exposure by selectively irradiating the resist film through the water-repellent film and the barrier film with exposing light with a liquid provided on the water-repellent film; removing the water-repellent film; removing the barrier film; and forming a resist pattern made of the resist film by developing the resist film after removing the barrier film and after the pattern exposure.

In the third or fourth pattern formation method, the water-repellent film having a water-repellent property is formed on the barrier film, and hence, the immersion liquid does not permeate into the resist film owing to the water-repellent film formed on the barrier film. Therefore, no water mark defect is caused in the resist film, and hence deterioration of the resist film otherwise caused by the liquid can be prevented. As a result, a fine pattern can be formed in a good shape.

In the third or fourth pattern formation method, the barrier film is preferably coated with a material including fluorine in the step of forming a water-repellent film.

In the third or fourth pattern formation method, the water-repellent film may include a polymer having fluorine in a principal chain.

In the third or fourth pattern formation method, the polymer may be a copolymer of tetrafluoroethylene.

The fifth pattern formation method of this invention includes the steps of forming a resist film on a substrate; forming a barrier film on the resist film; forming a waterproof film having a waterproof property on the barrier film; performing pattern exposure by selectively irradiating the resist film through the waterproof film and the barrier film with exposing light with a liquid provided on the waterproof film; removing the waterproof film; and removing the barrier film and forming a resist pattern made of the resist film by developing the resist film after removing the waterproof film and after the pattern exposure.

The sixth pattern formation method of this invention includes the steps of forming a resist film on a substrate; forming a barrier film on the resist film; forming a waterproof film having a waterproof property on the barrier film; performing pattern exposure by selectively irradiating the resist film through the waterproof film and the barrier film with exposing light with a liquid provided on the waterproof film; removing the waterproof film; removing the barrier film; and forming a resist pattern made of the resist film by developing the resist film after removing the barrier film and after the pattern exposure.

In the fifth or sixth pattern formation method, the waterproof film having a waterproof property is formed on the barrier film, and hence, the immersion liquid does not permeate into the resist film owing to the waterproof film formed on the barrier film. Therefore, no water mark defect is caused in the resist film, and hence deterioration of the resist film otherwise caused by the liquid can be prevented. As a result, a fine pattern can be formed in a good shape.

In the fifth or sixth pattern formation method, the waterproof film may include polyamide.

In this case, the polyamide may be a condensation polymer of ε-caprolactam, a co-condensation polymer of hexamethylene diamine and adipic acid or a co-condensation polymer of p-phenylene diamine and terephthalic acid.

Each of the second through sixth pattern formation methods preferably further includes, between the step of forming a barrier film and the step of performing pattern exposure, a step of annealing the barrier film. Thus, the denseness of the barrier film can be improved, so that the barrier film can be more insoluble in the liquid provided thereon for the exposure. However, when the denseness of the barrier film is excessively improved, it becomes difficult to remove the barrier film by dissolving it, and hence, the barrier film should be annealed in an appropriate temperature range. For example, the temperature is preferably 100°C or more and 150°C or less, which does not limit the invention.

The barrier film used for protecting the resist film in this invention is removed before or during the development.

As a solvent for removing the barrier film, any of an organic solvent, a fluorine solvent, a developer, a diluted developer and the like can be used. Examples of the organic solvent are n-butyl alcohol, sec-butyl alcohol, t-butyl alcohol, isopropyl alcohol, n-amyl alcohol and isoamyl alcohol. Examples of the fluorine solvent are 1,1,2,3,3,3-hexafluoro-1-diethylamino propane and triethylamine tris-hydrofluoride.

With respect to the degree of dilution of the diluted developer, the concentration is lower than that of a general developer, that is, 2.38 wt% tetramethylammonium hydroxide and is, for example, 0.01 % or more and 2% or less, which does not limit the invention.

For removing the barrier film of the first pattern formation method in which the polymer is thermally cross-linked and the barrier film of the second pattern formation method on which the water-repellent treatment is performed, an organic solvent or a fluorine solvent can be used.

The water-repellent film formed on the barrier film in the third or fourth pattern formation method and the waterproof film formed on the barrier film in the fifth or sixth pattern formation method may be removed before removing the barrier film. Also for removing the water-repellent film or the waterproof film, an organic solvent or a fluorine solvent may be used. Since the water-repellent film or the waterproof film is formed on the barrier film, the resist film can be advantageously prevented from being damaged in removing the water-repellent or waterproof film.

The barrier film of this invention may be removed during the development as in the third or fifth pattern formation method or before the development as in the fourth or sixth pattern formation method. Either case has its own advantage. First, when the barrier film is removed during the development of the resist film as in the third or fifth pattern formation method, the dissolution characteristic of the resist film can be controlled to be improved. In other words, when the barrier film is removed simultaneously with the development, the dissolution characteristic of the resist film can be controlled to some extent. Alternatively, when the barrier film is removed before the development as in the fourth or sixth pattern formation method, the subsequent development can be smoothly performed.

The dissolution characteristic of a resist film will now be described with reference to FIG. **21.** In general, when the dissolution characteristic of a resist film is high, the dissolution rate is abruptly increased when exposure exceeds a given threshold value (a threshold region of FIG. **21**) (as shown with a graph **A** of a broken line in FIG. **21**). As the change of the dissolution rate against the exposure is more abrupt, a difference in the solubility between an exposed portion and an unexposed portion of the resist film is larger, and hence, the resist pattern can be formed in a better shape. Accordingly, in the case where the barrier film is removed simultaneously with the development, the dissolution rate is wholly lowered during the removal of the barrier film, and hence, the change in a portion surrounded with a circle **C** in FIG. **21** can be made flatter. As a result, in the case where the actual resist film has the dissolution characteristic as shown with a graph **B,** the dissolution rate attained with smaller exposure can be adjusted to attain a comparatively constant solution state with a low dissolution rate even if the small exposure is varied to some extent. Accordingly, the difference in the solubility between an exposed portion and an unexposed portion of the resist film can be easily caused, resulting in easily forming a resist pattern in a good shape.

In any of the first through sixth pattern formation methods, the liquid may be water.

Alternatively, in any of the first through sixth pattern formation methods, the liquid may be an acidic solution.

In this case, the acidic solution may be a cesium sulfate (Cs₂SO₄) aqueous solution or a phosphoric acid (H₃PO₄) aqueous solution. Furthermore, the liquid may further include an additive such as a surfactant.

In any of the first through sixth pattern formation methods, the exposing light may be KrF excimer laser, Xe₂ laser, ArF excimer laser, F₂ laser, KrAr laser or Ar₂ laser.

### BRIEF DESCRIPTION OF THE DRAWINGS

FIGS. **1A, 1B, 1C** and **1D** are cross-sectional views for showing procedures in a pattern formation method according to Embodiment 1 of the invention;
FIGS. **2A, 2B** and **2C** are cross-sectional views for showing other procedures in the pattern formation method of Embodiment 1;
FIGS. **3A, 3B, 3C** and **3D** are cross-sectional views for showing procedures in a pattern formation method according to Embodiment 2 of the invention;
FIGS. **4A, 4B, 4C** and **4D** are cross-sectional views for showing other procedures in the pattern formation method of Embodiment 2;
FIGS. **5A, 5B, 5C** and **5D** are cross-sectional views for showing procedures in a pattern formation method according to Embodiment 3 of the invention;
FIGS. **6A, 6B, 6C** and **6D** are cross-sectional views for showing other procedures in the pattern formation method of Embodiment 3;
FIGS. **7A, 7B, 7C** and **7D** are cross-sectional views for showing procedures in a pattern formation method according to Embodiment 4 of the invention;
FIGS. **8A, 8B, 8C** and **8D** are cross-sectional views for showing other procedures in the pattern formation method of Embodiment 4;
FIG. **9** is a cross-sectional view for showing another procedure in the pattern formation method of Embodiment 4;
FIGS. **10A 10B, 10C** and **10D** are cross-sectional views for showing procedures in a pattern formation method according to Embodiment 5 of the invention;
FIGS. **11A, 11B, 11C** and **11D** are cross-sectional views for showing other procedures in the pattern formation method of Embodiment 5;
FIGS. **12A** and **12B** are cross-sectional views for showing other procedures in the pattern formation method of Embodiment 5;
FIGS. **13A, 13B, 13C** and **13D** are cross-sectional views for showing procedures in a pattern formation method according to Embodiment 6 of the invention;
FIGS. **14A, 14B, 14C** and **14D** are cross-sectional views for showing other procedures in the pattern formation method of Embodiment 6;
FIG. **15** is a cross-sectional view for showing another procedure in the pattern formation method of Embodiment 6;
FIGS. **16A, 16B, 16C** and **16D** are cross-sectional views for showing procedures in a pattern formation method according to Embodiment 7 of the invention;
FIGS. **17A, 17B, 17C** and **17D** are cross-sectional views for showing other procedures in the pattern formation method of Embodiment 7;
FIGS. **18A** and **18B** are cross-sectional views for showing other procedures in the pattern formation method of Embodiment 7;
FIGS. **19A, 19B, 19C** and **19D** are cross-sectional views for showing procedures in a conventional pattern formation method;
FIGS. **20A** and **20B** are cross-sectional views for showing other procedures in the conventional pattern formation method; and
FIG. **21** is a graph for explaining control of solubility of a resist in the pattern formation method of the invention.

### DETAILED DESCRIPTION OF THE INVENTION

### EMBODIMENT 1

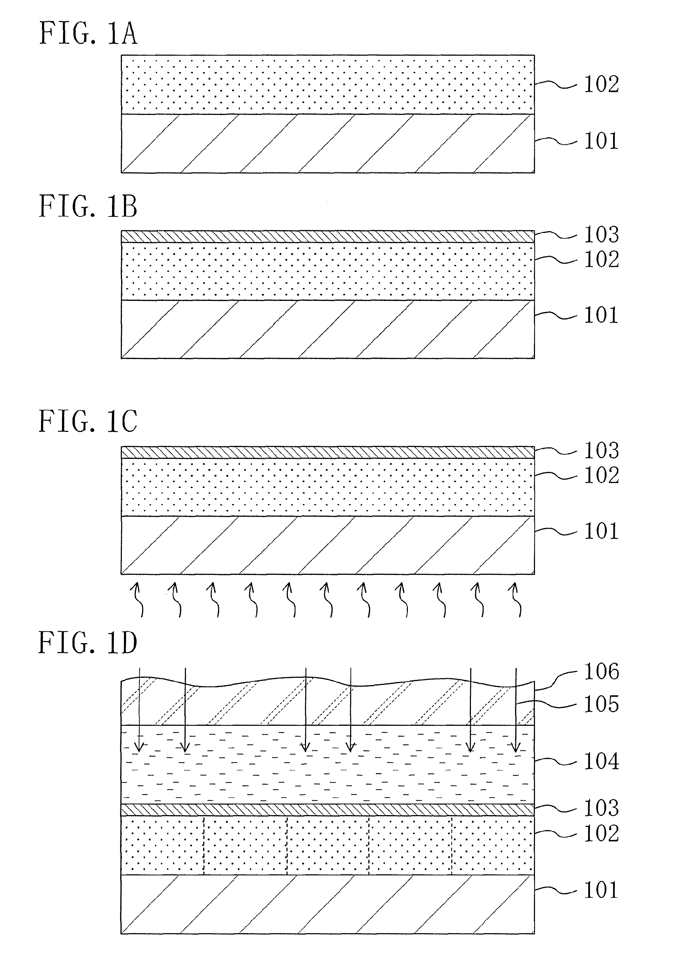

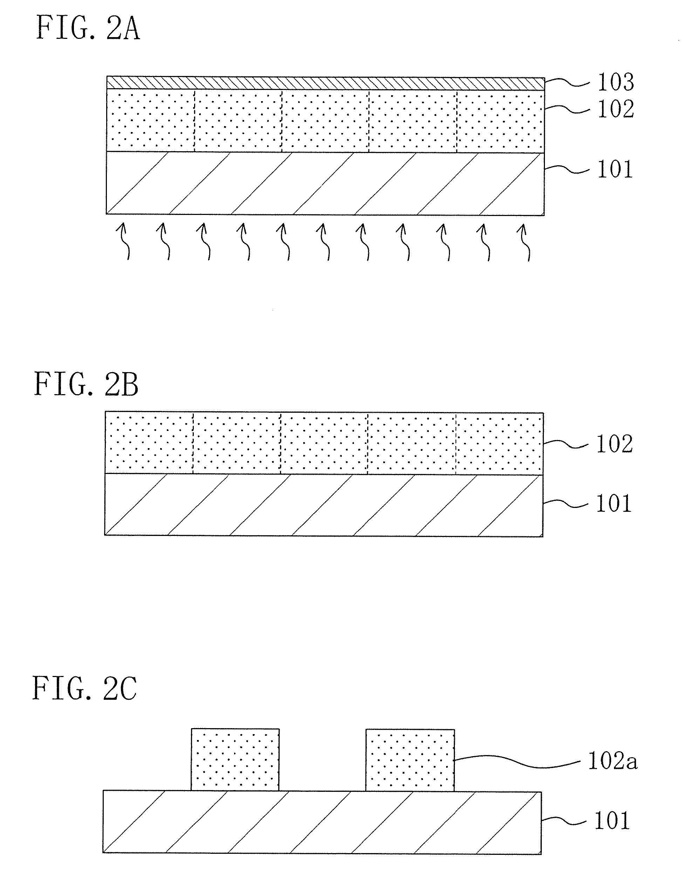

A pattern formation method according to Embodiment 1 of the invention will now be described with reference to FIGS. **1A** through **1D** and **2**A through **2C.**

First, a positive chemically amplified resist material having the following composition is prepared:

| | |
|---|---|
| Base polymer: poly((norbornene-5-methylene-t-butylcarboxylate) (50 mol%) - (maleic anhydride) (50 mol%)) | 2 g |
| Acid generator: triphenylsulfonium trifluoromethane sulfonate | 0.05 g |
| Quencher: triethanolamine | 0.002 g |
| Solvent: propylene glycol monomethyl ether acetate | 20 g |

Next, as shown in FIG. **1A,** the aforementioned chemically amplified resist material is applied on a substrate **1**01 so as to form a resist film **102** with a thickness of 0.35 µm.

Then, as shown in FIG. **1B,** by using a barrier film material according to this invention having the following composition, a barrier film **103** having a thickness of 60 nm is formed on the resist film **102** by, for example, spin coating:

| | |
|---|---|
| Base polymer: polyvinyl hexafluoroisopropyl alcohol | 1 g |
| Cross-linking agent: 1,3,5-tri(hydroxymethyl)melamine | 0.1 g |
| Solvent: n-butyl alcohol | 20 g |

Then, as shown in FIG. **1C,** the resultant barrier film **103** is annealed with a hot plate at a temperature of 120°C for 90 seconds, so as to improve the denseness of the barrier film **103.**

After the annealing, as shown in FIG. **1D,** with an immersion liquid **104** of water provided between the barrier film **103** and a projection lens **106** by, for example, a puddle method, pattern exposure is carried out by irradiating the resist film **102** through the liquid **104** and the barrier film **103** with exposing light **105** of ArF excimer laser with NA of 0.68 having passed through a mask (not shown).

After the pattern exposure, as shown in FIG. **2A,** the resist film **102** is baked with a hot plate at a temperature of 105°C for 60 seconds (post exposure bake).

Next, as shown in FIG. **2B,** the barrier film **103** is removed by using, for example, n-butyl alcohol, and thereafter, the resultant resist film **102** is developed with a 2.38 wt% tetramethylammonium hydroxide developer. In this manner, a resist pattern **102a** made of an unexposed portion of the resist film **102** and having a line width of 0.09 µm is formed in a good shape as shown in FIG. **2C.**

In this manner, according to Embodiment 1, in the procedure for forming a barrier film shown in FIG. **1B,** the material for the barrier film **103** to be formed on the resist film **102** includes 1,3,5-tri(hydroxyrnethyl)melamine, that is, a thermal cross-linking agent. Therefore, in the procedure for pattern exposure shown in FIG. **1D,** the cross-linking agent added to the base polymer of the barrier film **103** is heated so as to cause a cross-linking reaction therein, and hence, the liquid **104** can be prevented from permeating into the resist film **102.** Accordingly, no water mark defect is caused by the liquid **104** in the resist film **102.** As a result, deterioration of the resist film **102** otherwise caused through extraction of the acid generator or the like by the liquid **104** can be prevented, so that the resultant resist pattern **102a** can be formed in a good shape.

Although a melamine compound of 1,3,5-tri(hydroxymethyl)melamine is used as the cross-linking agent in Embodiment 1, this does not limit the invention but a similar good result can be attained by using an epoxy compound such as epoxy methanol.

Furthermore, although polyvinyl hexafluoroisopropyl alcohol is used as the base polymer of the barrier film **103,** polyvinyl alcohol or polyacrylic acid may be used instead.

### EMBODIMENT 2

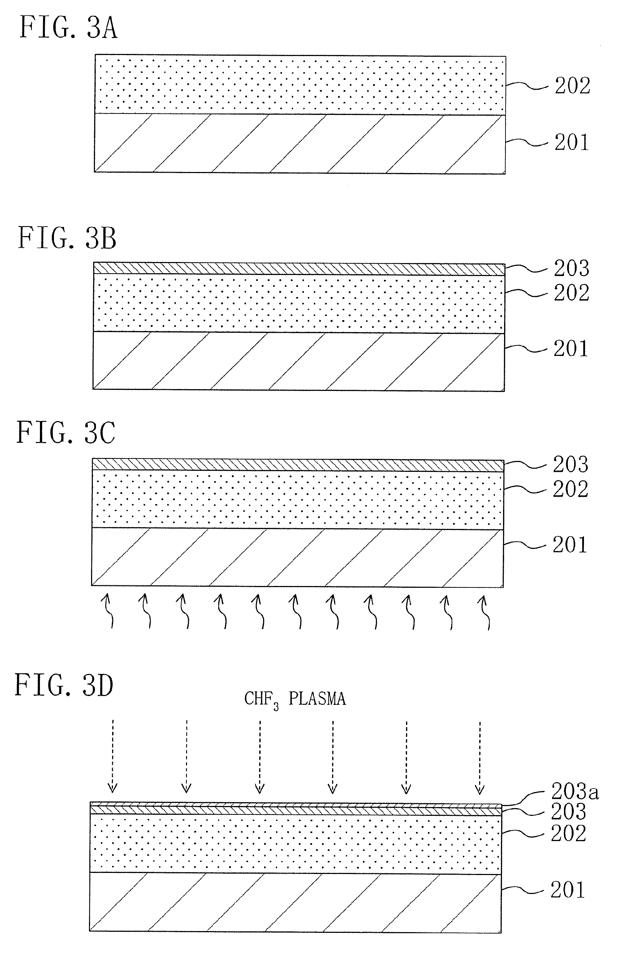

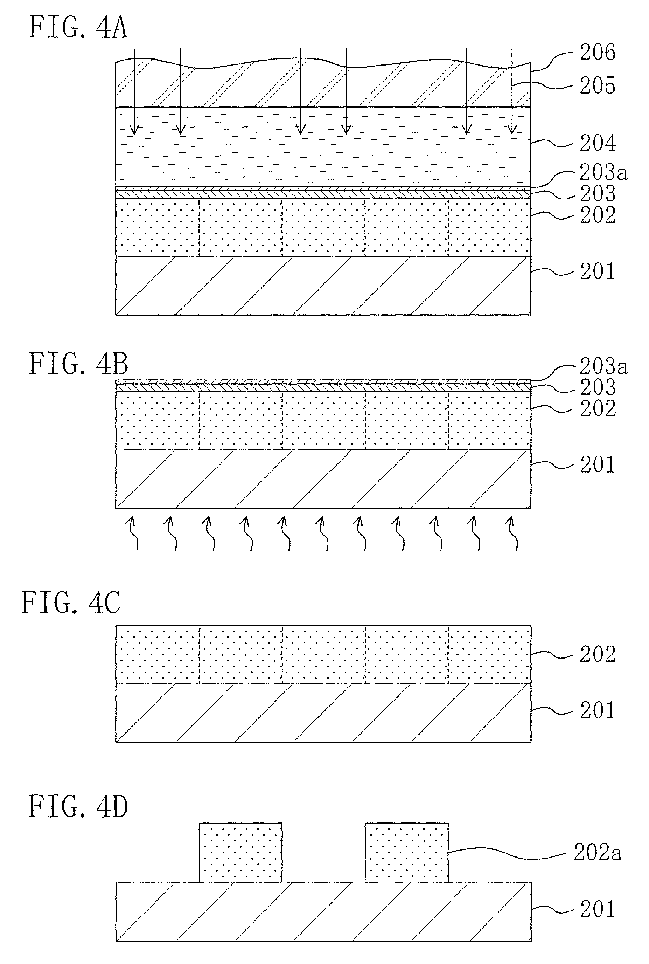

A pattern formation method according to Embodiment 2 of the invention will now be described with reference to FIGS. **3A** through **3D** and **4A** through **4D.**

First, a positive chemically amplified resist material having the following composition is prepared:

| | |
|---|---|
| Base polymer: poly((norbornene-5-methylene-t-butylcarboxylate) (50 mol%) - (maleic anhydride) (50 mol%)) | 2 g |
| Acid generator: triphenylsulfonium trifluoromethane sulfonate | 0.05 g |
| Quencher: triethanolamine | 0.002 g |
| Solvent: propylene glycol monomethyl ether acetate | 20 g |

Next, as shown in FIG. **3A,** the aforementioned chemically amplified resist material is applied on a substrate **201** so as to form a resist film **202** with a thickness of 0.35 µm.

Then, as shown in FIG. **3B,** by using a conventional barrier film material having the following composition, a barrier film **203** having a thickness of 50 nm is formed on the resist film **202** by, for example, the spin coating:

| | |
|---|---|
| Base polymer: polyvinyl hexafluoroisopropyl alcohol | 1 g |
| Solvent: n-butyl alcohol | 20 g |

Next, as shown in FIG. **3C,** the resultant barrier film **203** is annealed with a hot plate at a temperature of 110°C for 60 seconds, so as to improve the denseness of the barrier film **203.**

Thereafter, as shown in FIG. **3D,** the surface of the barrier film **203** is exposed to plasma of trifluoromethane (CHF₃) for 10 seconds as a water-repellent treatment. Thus, a fluorine adsorption layer **203a** is formed on the barrier film **203** through adsorption of fluorine (F) atoms.

Next, as shown in FIG. **4A,** with an immersion liquid **204** of water provided between the barrier film **203** having the fluorine adsorption layer **203a** thereon and a projection lens **206** by, for example, the puddle method, pattern exposure is carried out by irradiating the resist film **202** through the liquid **204** and the barrier film **203** with exposing light **205** of ArF excimer laser with NA of 0.68 having passed through a mask (not shown).

After the pattern exposure, as shown in FIG. **4B,** the resist film **202** is baked with a hot plate at a temperature of 105°C for 60 seconds (post exposure bake).

Next, as shown in FIG. **4C,** the barrier film **203** is removed by using, for example, triethylamine tris-hydrofluoride, and then, the resultant resist film **202** is developed with a 2.38 wt% tetramethylammonium hydroxide developer. In this manner, a resist pattern **202a** made of an unexposed portion of the resist film **202** and having a line width of 0.09 µm is formed in a good shape as shown in FIG. **4D.**

In this manner, according to Embodiment 2, in the procedure for a water-repellent treatment for a barrier film shown in FIG. **3D,** the fluorine adsorption layer 203a is formed by using the fluorine plasma on the barrier film **203** provided on the resist film **202.** Therefore, in the procedure for pattern exposure shown in FIG. **4A,** the liquid **204** can be prevented from permeating into the resist film **202** by the fluorine adsorption layer **203a** formed on the barrier film **203.** Accordingly, no water mark defect is caused by the liquid **204** in the resist film **202.** As a result, deterioration of the resist film **202** otherwise caused through extraction of the acid generator or the like by the liquid **204** can be prevented, so that the resultant resist pattern **202a** can be formed in a good shape.

Although the triethylamine tris-hydrofluoride is used for removing the barrier film **203** having been subjected to the water-repellent treatment using the fluorine plasma in Embodiment 2, this does not limit the invention but 1,1,2,3,3,3-hexafluoro-1-diethylamino propane or the like may be used instead.

### EMBODIMENT 3

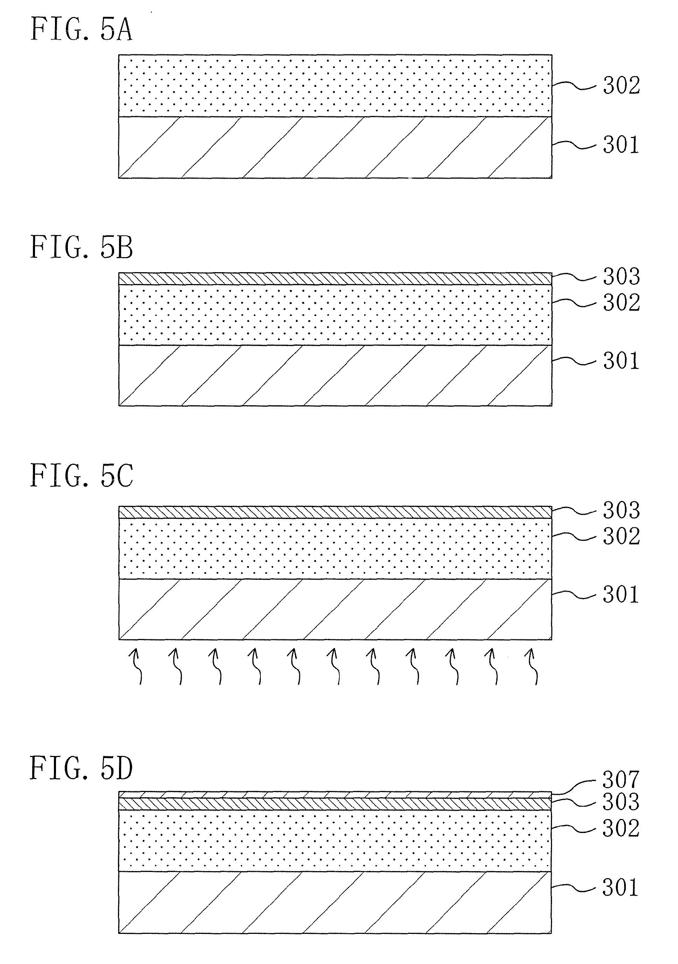

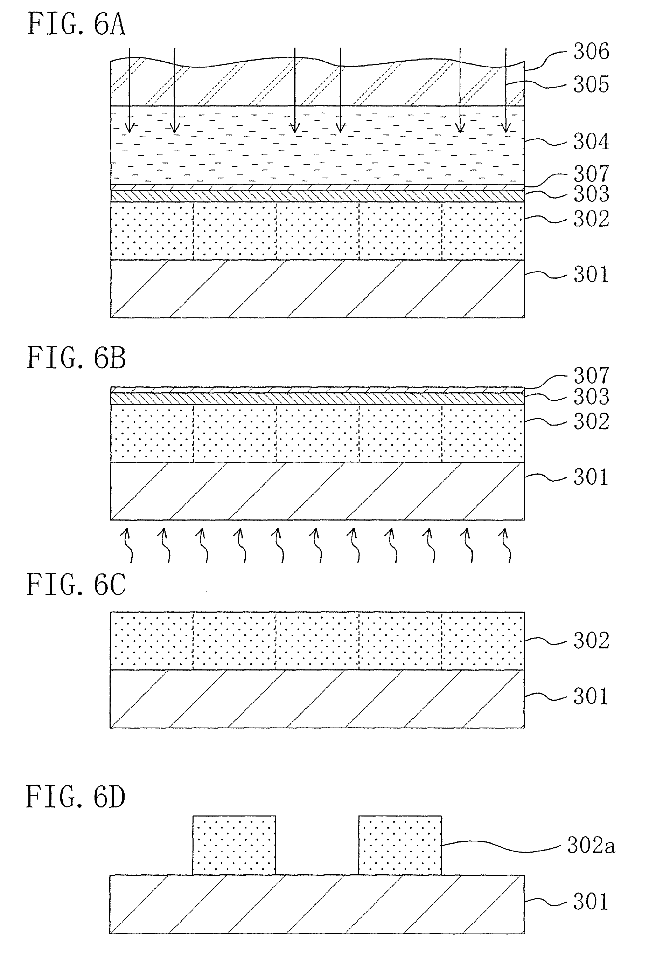

A pattern formation method according to Embodiment 3 of the invention will now be described with reference to FIGS. **5A** through **5D** and **6A** through **6D.**

First, a positive chemically amplified resist material having the following composition is prepared:

| | |
|---|---|
| Base polymer: poly((norbornene-5-methylene-t-butylcarboxylate) (50 mol%) - (maleic anhydride) (50 mol%)) | 2 g |
| Acid generator: triphenylsulfonium trifluoromethane sulfonate | 0.05 g |
| Quencher: triethanolamine | 0.002 g |
| Solvent: propylene glycol monomethyl ether acetate | 20 g |

Next, as shown in FIG. **5A,** the aforementioned chemically amplified resist material is applied on a substrate **301** so as to form a resist film **302** with a thickness of 0.35 µm.

Then, as shown in FIG. **5B,** by using a conventional barrier film material having the following composition, a barrier film **303** having a thickness of 50 nm is formed on the resist film **302** by, for example, the spin coating:

| | |
|---|---|
| Base polymer: polyvinyl hexafluoroisopropyl alcohol | 1 g |
| Solvent: n-butyl alcohol | 20 g |

Thereafter, as shown in FIG. **5C,** the resultant barrier film **303** is annealed with a hot plate at a temperature of 110°C for 60 seconds, so as to improve the denseness of the barrier film **303.**

Then, as shown in FIG. **5D,** a water-repellent film of a fluorine coating film **307** with a thickness of 10 nm is formed on the barrier film **303.** Specifically, the fluorine coating film **307** is obtained by applying a liquid including fluorine as a principal component, such as nonafluoro-t-butylmethyl ether or nonafluoro-t-butylethyl ether, by the spin coating. At this point, the fluorine coating film **307** may be subjected to annealing at a temperature of approximately 100°C.

Next, as shown in FIG. **6A,** with an immersion liquid **304** of water provided between the fluorine coating film **307** and a projection lens **306** by, for example, the puddle method, pattern exposure is carried out by irradiating the resist film **302** through the liquid **304,** the fluorine coating film **307** and the barrier film **303** with exposing light **305** of ArF excimer laser with NA of 0.68 having passed through a mask (not shown).

After the pattern exposure, as shown in FIG. **6B,** the resist film **302** is baked with a hot plate at a temperature of 105°C for 60 seconds (post exposure bake).

Next, the fluorine coating film **307** and the barrier film **303** are removed by using, for example, 1,1,2,3,3,3-hexafluoro-1-diethylamino propane, and the resultant resist film **302** is developed with a 2.38 wt% tetramethylammonium hydroxide developer. In this manner, a resist pattern **302a** made of an unexposed portion of the resist film **302** and having a line width of 0.09 µm is formed in a good shape as shown in FIG. **6D.**

In this manner, according to Embodiment 3, the fluorine coating film **307** having a water-repellent property is formed on the resist film **302** in the procedure for forming a water-repellent film shown in FIG. **5D.** Therefore, in the procedure for pattern exposure shown in FIG. **6A,** the liquid **304** can be prevented from permeating into the resist film **302** by the fluorine coating film **307** formed on the barrier film **303.** Accordingly, no water mark defect is caused by the liquid **304** in the resist film **302.** As a result, deterioration of the resist film **302** otherwise caused through extraction of the acid generator or the like by the liquid **304** can be prevented, so that the resultant resist pattern **302a** can be formed in a good shape.

Although 1,1,2,3,3,3-hexafluoro-1-diethylamino propane is used for removing the fluorine coating film **307** and the barrier film **303** in Embodiment 3, this does not limit the invention but triethylamine tris-hydrofluoride or the like may be used instead.

### EMBODIMENT 4

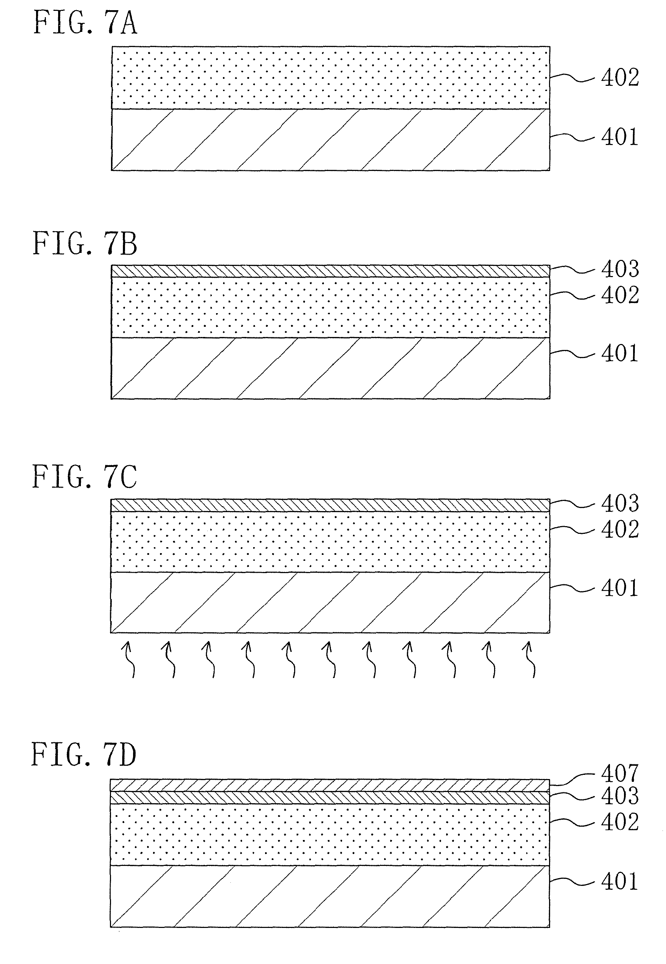

A pattern formation method according to Embodiment 4 of the invention will now be described with reference to FIGS. **7A** through **7D, 8A** through **8D** and **9.**

First, a positive chemically amplified resist material having the following composition is prepared:

| | |
|---|---|
| Base polymer: poly((norbornene-5-methylene-t-butylcarboxylate) (50 mol%) - (maleic anhydride) (50 mol%)) | 2 g |
| Acid generator: triphenylsulfonium trifluoromethane sulfonate | 0.05 g |
| Quencher: triethanolamine | 0.002 g |
| Solvent: propylene glycol monomethyl ether acetate | 20 g |

Next, as shown in FIG. **7A,** the aforementioned chemically amplified resist material is applied on a substrate **401** so as to form a resist film **402** with a thickness of 0.35 µm.

Then, as shown in FIG. **7B,** by using a conventional barrier film material having the following composition, a barrier film **403** having a thickness of 30 nm is formed on the resist film **402** by, for example, the spin coating:

| | |
|---|---|
| Base polymer: polyvinyl hexafluoroisopropyl alcohol | 1 g |
| Solvent: n-butyl alcohol | 20 g |

Next, as shown in FIG. **7C,** the resultant barrier film **403** is annealed with a hot plate at a temperature of 110°C for 60 seconds, so as to improve the denseness of the barrier film **403.**

After the annealing, as shown in FIG. **7D,** a water-repellent film **407** having a thickness of 25 nm and made of poly(tetrafluoroethylene (60 mol%)-t-butyl acrylate (40 mol%)), that is, a polymer including fluorine in a principal chain, is formed on the barrier film **403.**

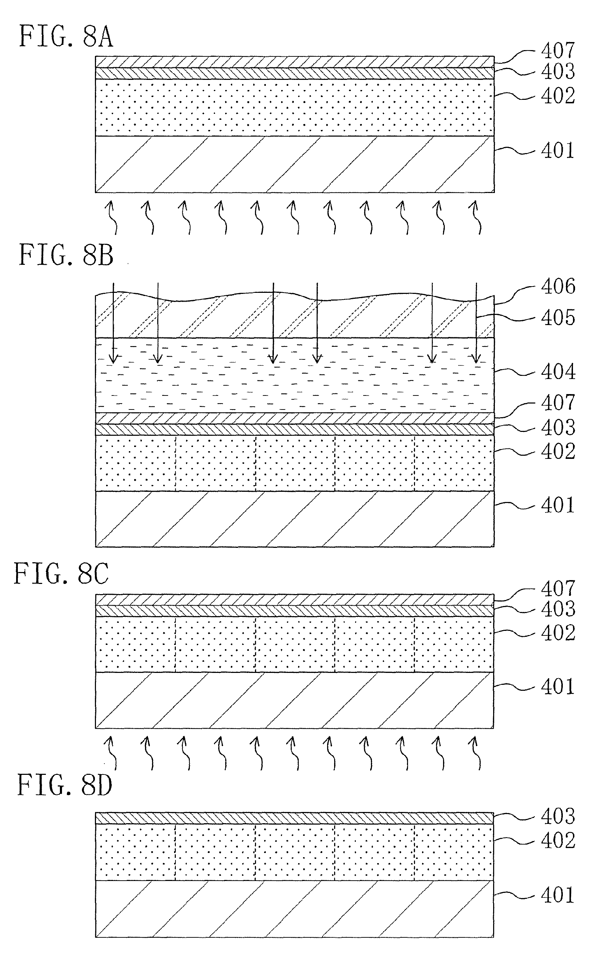

Then, as shown in FIG. **8A,** the resultant water-repellent film **407** is annealed with a hot plate at a temperature of 115°C for 60 seconds.

Next, as shown in FIG. **8B,** with an immersion liquid **404** of water provided between the barrier film **403** having the water-repellent film **407** thereon and a projection lens **406** by, for example, the puddle method, pattern exposure is carried out by irradiating the resist film **402** through the liquid **404,** the water-repellent film **407** and the barrier film **403** with exposing light **405** of ArF excimer laser with NA of 0.68 having passed through a mask (not shown).

After the pattern exposure, as shown in FIG. **8C,** the resist film **402** is baked with a hot plate at a temperature of 105°C for 60 seconds (post exposure bake).

Next, as shown in FIG. **8D,** the water-repellent film **407** is removed by using, for example, 1,1,2,3,3,3-hexafluoro-1-diethylamino propane.

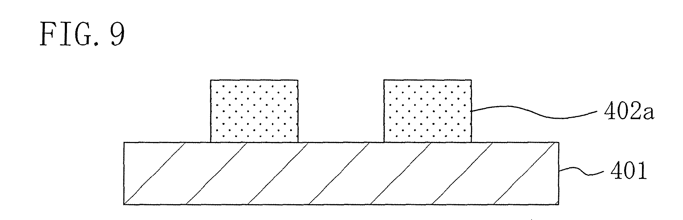

Then, the barrier film **403** is removed and the resultant resist film **402** is developed with a 2.38 wt% tetramethylammonium hydroxide developer. In this manner, a resist pattern **402a** made of an unexposed portion of the resist film **402** and having a line width of 0.09 µm is formed in a good shape as shown in FIG. **9.**

In this manner, according to Embodiment 4, the water-repellent film **407** having a water-repellent property and including fluorine in the principal chain is formed on the resist film **402** in the procedure for forming a water-repellent film shown in FIG. **7D.** Therefore, in the procedure for pattern exposure shown in FIG. **8B,** the liquid **404** can be prevented from permeating into the resist film **402** by the water-repellent film **407** formed on the barrier film **403.** Accordingly, no water mark defect is caused by the liquid **404** in the resist film **402.** As a result, deterioration of the resist film **402** otherwise caused through extraction of the acid generator or the like by the liquid **404** can be prevented, so that the resultant resist pattern **4**02a can be formed in a good shape.

Although 1,1,2,3,3,3-hexafluoro-1-diethylamino propane is used for removing the water-repellent film **407** in Embodiment 4, this does not limit the invention but triethylamine tris-hydrofluoride or the like may be used instead.

### EMBODIMENT 5

A pattern formation method according to Embodiment 5 of the invention will now be described with reference to FIGS. **10A** through **10D, 11A** through **11D, 12A** and **12B.**

First, a positive chemically amplified resist material having the following composition is prepared:

| | |
|---|---|
| Base polymer: poly((norbornene-5-methylene-t-butylcarboxylate) (50 mol%) - (maleic anhydride) (50 mol%)) | 2 g |
| Acid generator: triphenylsulfonium trifluoromethane sulfonate | 0.05 g |
| Quencher: triethanolamine | 0.002 g |
| Solvent: propylene glycol monomethyl ether acetate | 20 g |

Next, as shown in FIG. **10A,** the aforementioned chemically amplified resist material is applied on a substrate **501** so as to form a resist film **502** with a thickness of 0.35 µm.

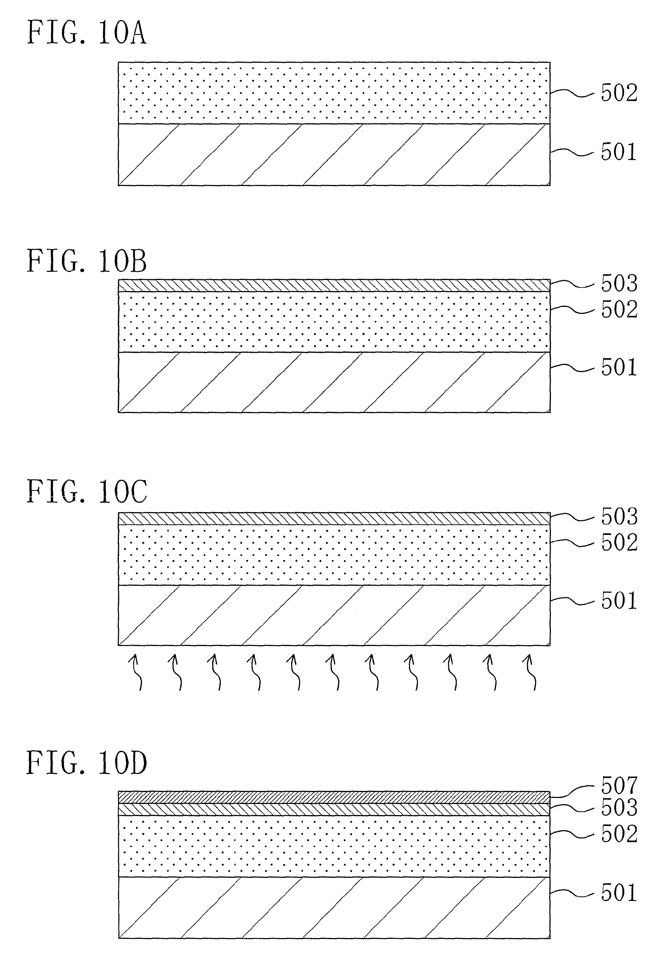

Then, as shown in FIG. **10B,** by using a conventional barrier film material having the following composition, a barrier film **503** having a thickness of 30 nm is formed on the resist film **502** by, for example, the spin coating:

| | |
|---|---|
| Base polymer: polyvinyl hexafluoroisopropyl alcohol | 1 g |
| Solvent: n-butyl alcohol | 20 g |

Next, as shown in FIG. **10C,** the resultant barrier film **503** is annealed with a hot plate at a temperature of 110°C for 60 seconds, so as to improve the denseness of the barrier film **503.**

After the annealing, as shown in FIG. **10D,** a water-repellent film **507** having a thickness of 25 nm and made of poly(tetrafluoroethylene (60 mol%)-t-butyl acrylate (40 mol%)), that is, a polymer including fluorine in a principal chain, is formed on the barrier film **503.**

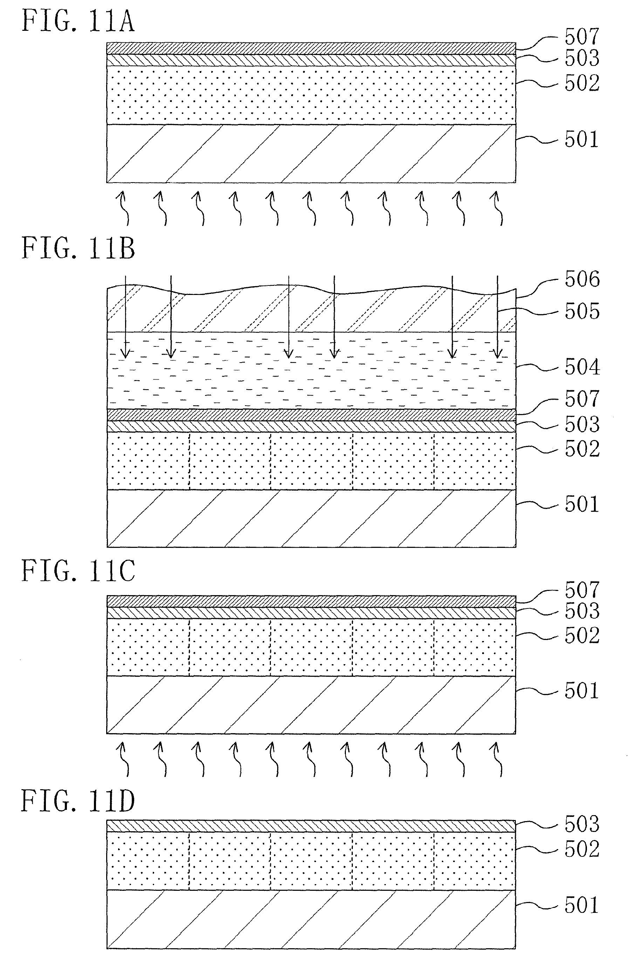

Then, as shown in FIG. **11A,** the resultant water-repellent film **507** is annealed with a hot plate at a temperature of 115°C for 60 seconds.

Next, as shown in FIG. **11B,** with an immersion liquid **504** of water provided between the barrier film **503** having the water-repellent film **507** thereon and a projection lens **506** by, for example, the puddle method, pattern exposure is carried out by irradiating the resist film **502** through the liquid **504,** the water-repellent film **507** and the barrier film **503** with exposing light **505** of ArF excimer laser with NA of 0.68 having passed through a mask (not shown).

After the pattern exposure, as shown in FIG. **11C,** the resist film **502** is baked with a hot plate at a temperature of 105°C for 60 seconds (post exposure bake).

Next, as shown in FIG. **11D,** the water-repellent film **507** is removed by using, for example, 1,1,2,3,3,3-hexafluoro-1-diethylamino propane.

Then, as shown in FIG. **12A,** the barrier film **503** is removed by using a 0.002 wt% tetramethylammonium hydroxide aqueous solution (diluted alkaline developer).

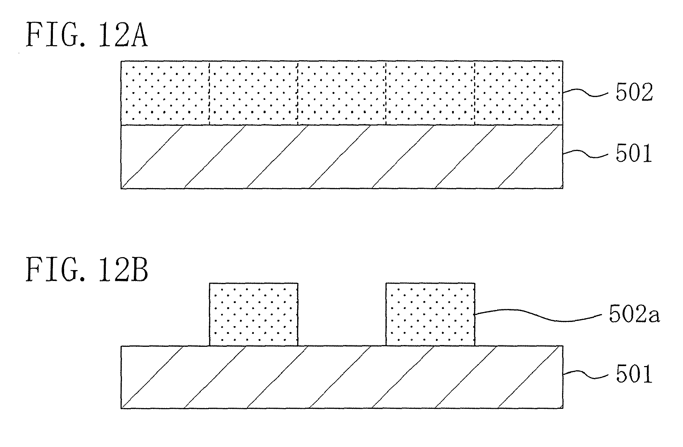

After removing the barrier film **503,** the resultant resist film **502** is developed with a 2.38 wt% tetramethylammonium hydroxide developer. In this manner, a resist pattern **502a** made of an unexposed portion of the resist film **502** and having a line width of 0.09 µm is formed in a good shape as shown in FIG. **12B.**

In this manner, according to Embodiment 5, the water-repellent film **507** having a water-repellent property and including fluorine in the principal chain is formed on the resist film **502** in the procedure for forming a water-repellent film shown in FIG. **10D.** Therefore, in the procedure for pattern exposure shown in FIG. **11B,** the liquid **504** can be prevented from permeating into the resist film **502** by the water-repellent film **507** formed on the barrier film **503.** Accordingly, no water mark defect is caused by the liquid **504** in the resist film **502.** As a result, deterioration of the resist film **502** otherwise caused through extraction of the acid generator or the like by the liquid **504** can be prevented, so that the resultant resist pattern **502a** can be formed in a good shape.

Although 1,1,2,3,3,3-hexafluoro-1-diethylamino propane is used for removing the water-repellent film **507** in Embodiment 5, this does not limit the invention but triethylamine tris-hydrofluoride or the like may be used instead.

As described above, since the barrier film **403** is removed with the developer at the same time as the development in Embodiment 4, and hence, the solubility of the resist film **402** can be controlled. On the other hand, since the barrier film **503** is removed before the development in this embodiment, the barrier film **503** can be definitely removed and hence the development can be smoothly performed.

### EMBODIMENT 6

A pattern formation method according to Embodiment 6 of the invention will now be described with reference to FIGS. **13A** through **13D, 14A** through **14D** and **15.**

First, a positive chemically amplified resist material having the following composition is prepared:

| | |
|---|---|
| Base polymer: poly((norbornene-5-methylene-t-butylcarboxylate) (50 mol%) - (maleic anhydride) (50 mol%)) | 2 g |
| Acid generator: triphenylsulfonium trifluoromethane sulfonate | 0.05 g |
| Quencher: triethanolamine | 0.002 g |
| Solvent: propylene glycol monomethyl ether acetate | 20 g |

Next, as shown in FIG. **13A,** the aforementioned chemically amplified resist material is applied on a substrate **601** so as to form a resist film **602** with a thickness of 0.35 µm.

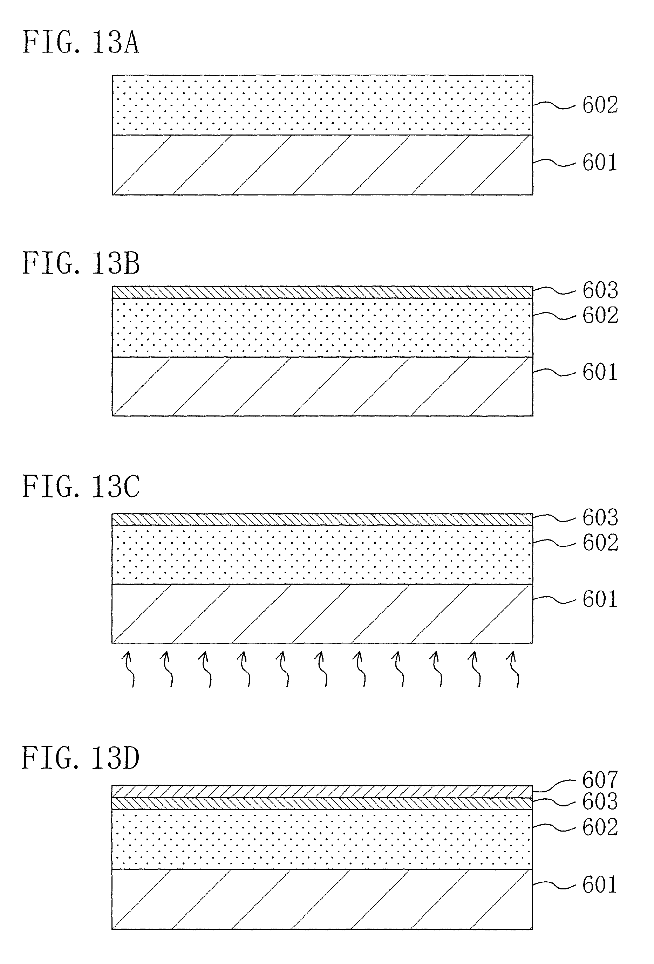

Then, as shown in FIG. **13B,** by using a conventional barrier film material having the following composition, a barrier film **603** having a thickness of 40 nm is formed on the resist film **602** by, for example, the spin coating:

| | |
|---|---|
| Base polymer: polyvinyl hexafluoroisopropyl alcohol | 1 g |
| Solvent: n-butyl alcohol | 20 g |

Next, as shown in FIG. **13C,** the resultant barrier film **603** is annealed with a hot plate at a temperature of 110°C for 60 seconds, so as to improve the denseness of the barrier film **603.**

After the annealing, as shown in FIG. **13D,** a waterproof film **607** having a thickness of 20 nm and made of a condensation polymer of ε-caprolactam, that is, polyamide, is formed on the barrier film **603.**

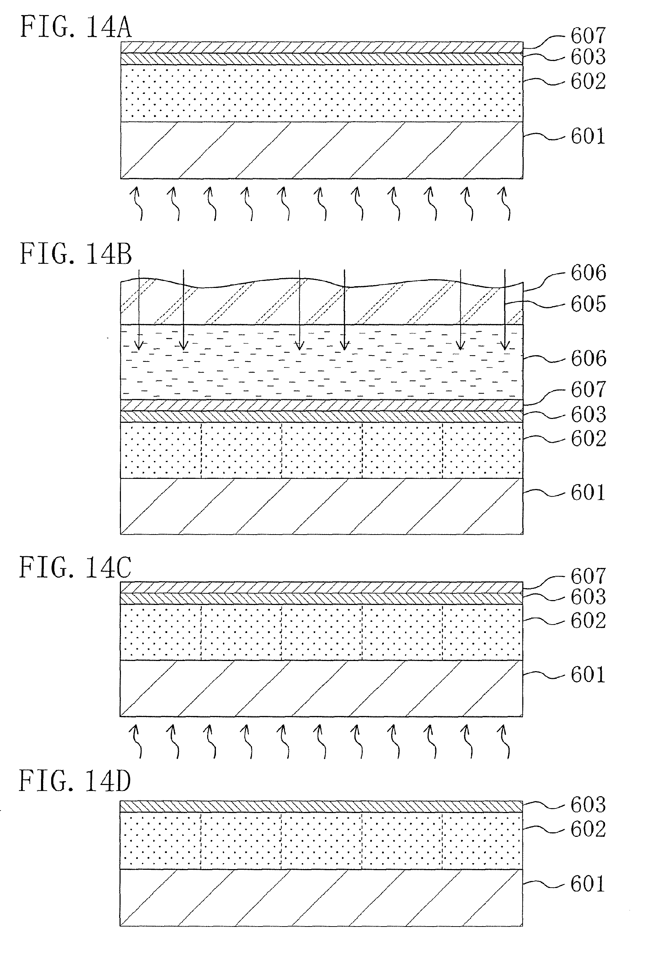

Then, as shown in FIG. **14A,** the resultant waterproof film **607** is annealed with a hot plate at a temperature of 125°C for 60 seconds.

Next, as shown in FIG. **14B,** with an immersion liquid **604** of water provided between the barrier film **603** having the waterproof film **607** thereon and a projection lens **606** by, for example, the puddle method, pattern exposure is carried out by irradiating the resist film **602** through the liquid **604,** the waterproof film **607** and the barrier film **603** with exposing light **605** of ArF excimer laser with NA of 0.68 having passed through a mask (not shown).

After the pattern exposure, as shown in FIG. **14C,** the resist film **602** is baked with a hot plate at a temperature of 105°C for 60 seconds (post exposure bake).

Next, as shown in FIG. **14D,** the waterproof film **607** is removed by using, for example, triethylamine tris-hydrofluoride.

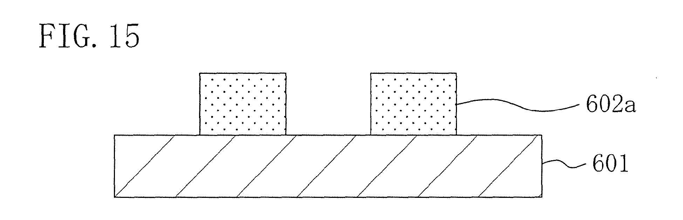

Then, the barrier film **603** is removed and the resultant resist film **602** is developed with a 2.38 wt% tetramethylammonium hydroxide developer. In this manner, a resist pattern 602a made of an unexposed portion of the resist film **602** and having a line width of 0.09 µm is formed in a good shape as shown in FIG. **15.**

In this manner, according to Embodiment 6, the waterproof film **607** made of the polyamide and having a waterproof property is formed on the resist film **602** in the procedure for forming a waterproof film shown in FIG. **13D.** Therefore, in the procedure for pattern exposure shown in FIG. **14B,** the liquid **604** can be prevented from permeating into the resist film **602** by the waterproof film **607** formed on the barrier film **603.** Accordingly, no water mark defect is caused by the liquid **604** in the resist film **602.** As a result, deterioration of the resist film **602** otherwise caused through extraction of the acid generator or the like by the liquid **604** can be prevented, so that the resultant resist pattern **602a** can be formed in a good shape.

Although triethylamine tris-hydrofluoride is used for removing the waterproof film **607** in Embodiment 6, this does not limit the invention but 1,1,2,3,3,3-hexafluoro-1-diethylamino propane or the like may be used instead.

### EMBODIMENT 7

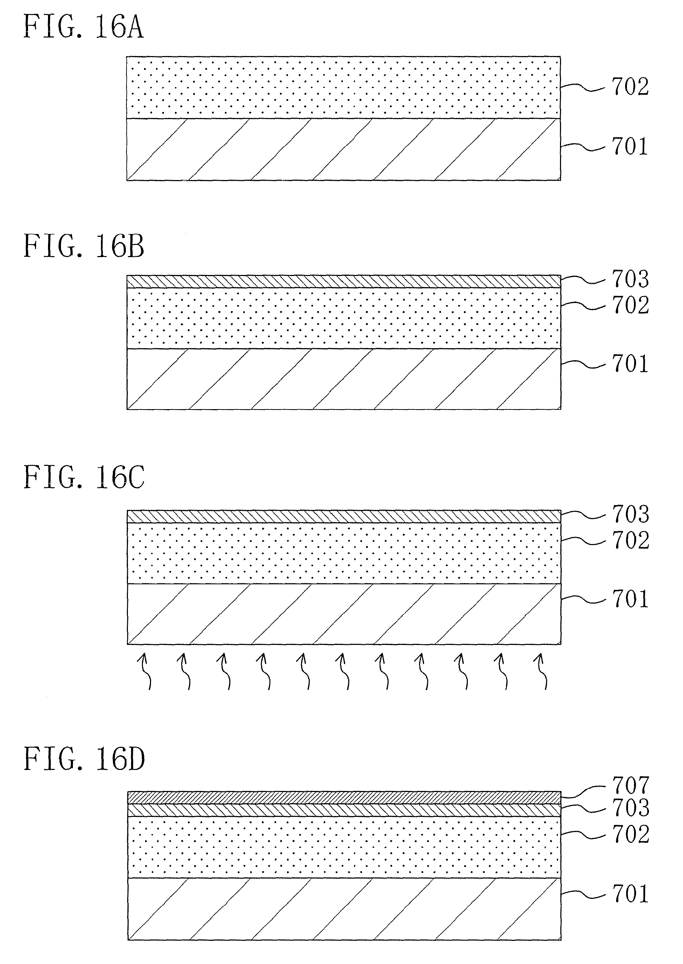

A pattern formation method according to Embodiment 7 of the invention will now be described with reference to FIGS. **16A** through **16D, 17A** through **17D, 18A** and **18B.**

First, a positive chemically amplified resist material having the following composition is prepared:

| | |
|---|---|
| Base polymer: poly((norbornene-5-methylene-t-butylcarboxylate) (50 mol%) - (maleic anhydride) (50 mol%)) | 2 g |
| Acid generator: triphenylsulfonium trifluoromethane sulfonate | 0.05 g |
| Quencher: triethanolamine | 0.002 g |
| Solvent: propylene glycol monomethyl ether acetate | 20 g |

Next, as shown in FIG. **16A,** the aforementioned chemically amplified resist material is applied on a substrate **701** so as to form a resist film **702** with a thickness of 0.35 µm.

Then, as shown in FIG. **16B,** by using a conventional barrier film material having the following composition, a barrier film **703** having a thickness of 40 nm is formed on the resist film **702** by, for example, the spin coating:

| | |
|---|---|
| Base polymer: polyvinyl hexafluoroisopropyl alcohol | 1 g |
| Solvent: n-butyl alcohol | 20 g |

Next, as shown in FIG. **16C,** the resultant barrier film **703** is annealed with a hot plate at a temperature of 110°C for 60 seconds, so as to improve the denseness of the barrier film **703.**

After the annealing, as shown in FIG. **16D,** a waterproof film **707** having a thickness of 20 nm and made of a condensation polymer of ε-caprolactam, that is, polyamide, is formed on the barrier film **703.**

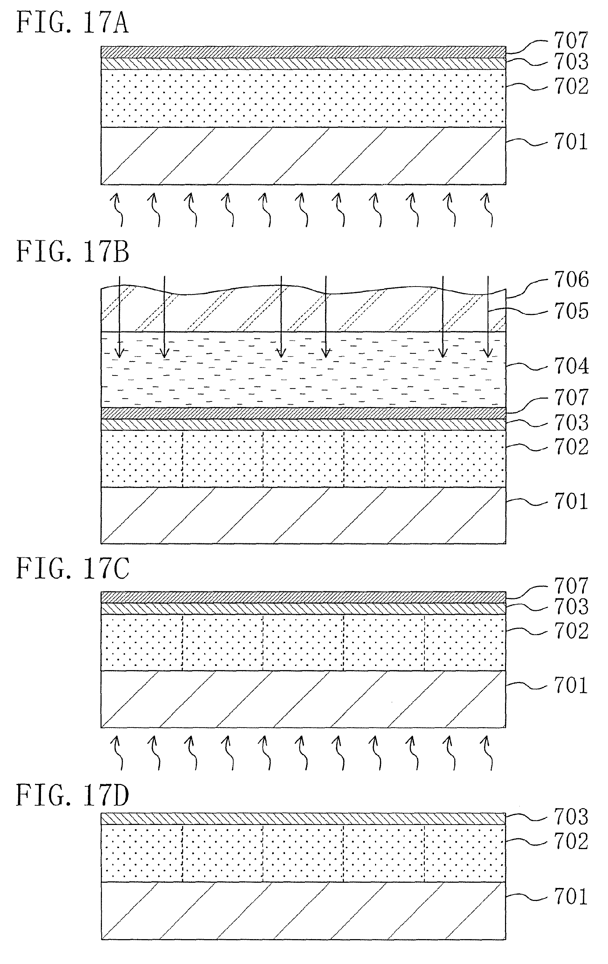

Then, as shown in FIG. **17A,** the resultant waterproof film **707** is annealed with a hot plate at a temperature of 115°C for 60 seconds.

Next, as shown in FIG. **17B,** with an immersion liquid **704** of water provided between the barrier film **703** having the waterproof film **707** thereon and a projection lens **706** by, for example, the puddle method, pattern exposure is carried out by irradiating the resist film **702** through the liquid **704,** the waterproof film **707** and the barrier film **703** with exposing light **705** of ArF excimer laser with NA of 0.68 having passed through a mask (not shown).

After the pattern exposure, as shown in FIG. **17C,** the resist film **702** is baked with a hot plate at a temperature of 105°C for 60 seconds (post exposure bake).

Next, as shown in FIG. **17D,** the waterproof film **707** is removed by using, for example, triethylamine tris-hydrofluoride.

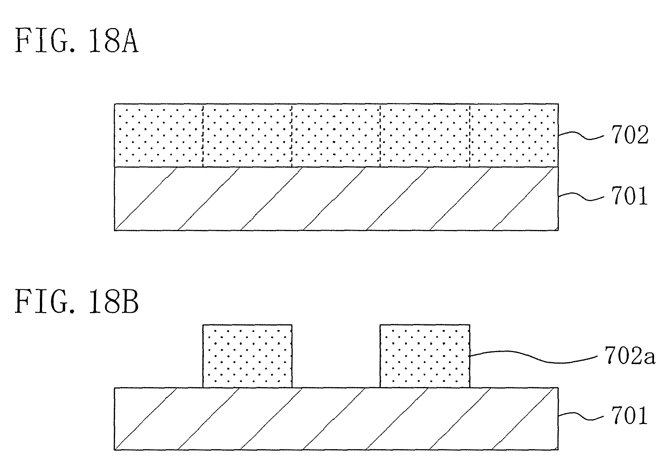

Then, as shown in FIG. **18A,** the barrier film **703** is removed by using a 0.002 wt% tetramethylammonium hydroxide aqueous solution (a diluted alkaline developer).

After removing the barrier film **703,** the resultant resist film **702** is developed with a 2.38 wt% tetramethylammonium hydroxide developer. In this manner, a resist pattern **702a** made of an unexposed portion of the resist film **702** and having a line width of 0.09 µm is formed in a good shape as shown in FIG. **18B.**

In this manner, according to Embodiment 7, the waterproof film **707** made of the polyamide and having a waterproof property is formed on the resist film **702** in the procedure for forming a waterproof film shown in FIG. **16D.** Therefore, in the procedure for pattern exposure shown in FIG. **17B,** the liquid **704** can be prevented from permeating into the resist film **702** by the waterproof film **707** formed on the barrier film **703.** Accordingly, no water mark defect is caused by the liquid **704** in the resist film **702.** As a result, deterioration of the resist film **702** otherwise caused through extraction of the acid generator or the like by the liquid **704** can be prevented, so that the resultant resist pattern **702a** can be formed in a good shape.

Although triethylamine tris-hydrofluoride is used for removing the waterproof film **707** in Embodiment 7, this does not limit the invention but 1,1,2,3,3,3-hexafluoro-1-diethylamino propane or the like may be used instead.

Since the barrier film **603** is removed with the developer at the same time as the development in Embodiment 6, the solubility of the resist film **602** can be controlled. On the other hand, since the barrier film **703** is removed before the development in this embodiment, the barrier film **703** can be definitely removed and hence the development can be smoothly performed.

Although the thickness of the barrier film is 30 nm through 60 nm in each of Embodiments 1 through 7, the thickness may be not less than approximately 30 nm and not more than approximately 100 nm, which does not limit the invention.

In addition, although the barrier film is annealed for improving the denseness thereof after forming the barrier film in each embodiment, this annealing for the barrier film is not always necessary but can be appropriately performed in accordance with the composition, the thickness and the like of the barrier film.

Furthermore, cesium sulfate may be added to the immersion liquid in each of Embodiments 1 through 7, so as to increase the refractive index of the liquid. It is noted that the compound to be added for this purpose is not limited to cesium sulfate but may be phosphoric acid (H₃PO₄). Moreover, a surfactant may be further added to the immersion liquid.

Although the exposing light is ArF excimer laser in each embodiment, the exposing light is not limited to it but may be KrF excimer laser, Xe₂ laser, F₂ laser, KrAr laser or Ar₂ laser instead.

Furthermore, the puddle method is employed for providing the immersion liquid in each embodiment, which does not limit the invention, and for example, a dip method in which the whole substrate is dipped in the immersion liquid may be employed instead.

Moreover, although a positive chemically amplified resist is used for forming the resist film in each embodiment, the present invention is applicable also to a negative chemically amplified resist. Furthermore, the resist is not limited to a chemically amplified resist.

As described so far, according to the barrier film material and the pattern formation method using the same of this invention, an immersion liquid can be prevented from permeating into a resist film through a barrier film formed thereon, so that a fine resist pattern can be formed in a good shape. Accordingly, the present invention is useful as a method for forming a fine pattern to be employed in fabrication process or the like for semiconductor devices.

## Claims

1. A barrier film material for use in forming a barrier film between a resist film and an immersion liquid when exposure of said resist film is performed with said immersion liquid provided above said resist film, comprising a polymer and a cross-linking agent for thermally causing a cross-linking reaction of said polymer.

2. The barrier film material of Claim 1,
wherein said cross-linking agent includes a melamine compound or an epoxy compound.

3. The barrier film material of Claim 1,
wherein said polymer is polyvinyl alcohol, polyacrylic acid or polyvinyl hexafluoroisopropyl alcohol.

4. A pattern formation method comprising the steps of:
forming a resist film on a substrate;
forming, on said resist film, a barrier film including a polymer and a cross-linking agent for thermally causing a cross-linking reaction of said polymer;
annealing said barrier film for cross-linking said polymer by said cross-linking agent;
performing pattern exposure by selectively irradiating said resist film through said barrier film with exposing light with a liquid provided on said barrier film;
removing said barrier film; and
forming a resist pattern made of said resist film by developing said resist film after removing said barrier film and after the pattern exposure.

5. The pattern formation method of Claim 4,
wherein said cross-linking agent includes a melamine compound or an epoxy compound.

6. The pattern formation method of Claim 4,
wherein said polymer is polyvinyl alcohol, polyacrylic acid or polyvinyl hexafluoroisopropyl alcohol.

7. The pattern formation method of Claim 4,
wherein said liquid is water.

8. The pattern formation method of Claim 4,
wherein said liquid is an acidic solution.

9. The pattern formation method of Claim 8,
wherein said acidic solution is a cesium sulfate aqueous solution or a phosphoric acid aqueous solution.

10. The pattern formation method of Claim 4,
wherein said exposing light is KrF excimer laser, Xe₂ laser, ArF excimer laser, F₂ laser, KrAr laser or Ar₂ laser.

11. A pattern formation method comprising the steps of:
forming a resist film on a substrate;
forming a barrier film on said resist film;
performing a water-repellent treatment for providing a water-repellent property to a surface of said barrier film;
performing pattern exposure by selectively irradiating said resist film through said barrier film with exposing light with a liquid provided on said barrier film having been subjected to the water-repellent treatment;
removing said barrier film; and
forming a resist pattern made of said resist film by developing said resist film after removing said barrier film and after the pattern exposure.

12. The pattern formation method of Claim 11,
wherein said barrier film is exposed to plasma including fluorine in the step of performing a water-repellent treatment.

13. The pattern formation method of Claim 11, further comprising, between the step of forming a barrier film and the step of performing pattern exposure, a step of annealing said barrier film.

14. The pattern formation method of Claim 11,
wherein said liquid is water.

15. The pattern formation method of Claim 11,
wherein said liquid is an acidic solution.

16. The pattern formation method of Claim 15,
wherein said acidic solution is a cesium sulfate aqueous solution or a phosphoric acid aqueous solution.

17. The pattern formation method of Claim 11,
wherein said exposing light is KrF excimer laser, Xe₂ laser, ArF excimer laser, F₂ laser, KrAr laser or Ar₂ laser.

18. A pattern formation method comprising the steps of:
forming a resist film on a substrate;
forming a barrier film on said resist film;
forming a water-repellent film having a water-repellent property on said barrier film;
performing pattern exposure by selectively irradiating said resist film through said water-repellent film and said barrier film with exposing light with a liquid provided on said water-repellent film;
removing said water-repellent film; and
removing said barrier film and forming a resist pattern made of said resist film by developing said resist film after removing said water-repellent film and after the pattern exposure.

19. The pattern formation method of Claim 18,
wherein said barrier film is coated with a material including fluorine in the step of forming a water-repellent film.

20. The pattern formation method of Claim 18,
wherein said water-repellent film includes a polymer having fluorine in a principal chain.

21. The pattern formation method of Claim 20,
wherein said polymer is a copolymer of tetrafluoroethylene.

22. The pattern formation method of Claim 18, further comprising, between the step of forming a barrier film and the step of performing pattern exposure, a step of annealing said barrier film.

23. The pattern formation method of Claim 18,
wherein said liquid is water.

24. The pattern formation method of Claim 18,
wherein said liquid is an acidic solution.

25. The pattern formation method of Claim 24,
wherein said acidic solution is a cesium sulfate aqueous solution or a phosphoric acid aqueous solution.

26. The pattern formation method of Claim 18,
wherein said exposing light is KrF excimer laser, Xe₂ laser, ArF excimer laser, F₂ laser, KrAr laser or Ar₂ laser.

27. A pattern formation method comprising the steps of:
forming a resist film on a substrate;
forming a barrier film on said resist film;
forming a water-repellent film having a water-repellent property on said barrier film;
performing pattern exposure by selectively irradiating said resist film through said water-repellent film and said barrier film with exposing light with a liquid provided on said water-repellent film;
removing said water-repellent film;
removing said barrier film; and
forming a resist pattern made of said resist film by developing said resist film after removing said barrier film and after the pattern exposure.

28. The pattern formation method of Claim 27,
wherein said barrier film is coated with a material including fluorine in the step of forming a water-repellent film.

29. The pattern formation method of Claim 27,
wherein said water-repellent film includes a polymer having fluorine in a principal chain.

30. The pattern formation method of Claim 29,
wherein said polymer is a copolymer of tetrafluoroethylene.

31. The pattern formation method of Claim 27, further comprising, between the step of forming a barrier film and the step of performing pattern exposure, a step of annealing said barrier film.

32. The pattern formation method of Claim 27,
wherein said liquid is water.

33. The pattern formation method of Claim 27,
wherein said liquid is an acidic solution.

34. The pattern formation method of Claim 33,
wherein said acidic solution is a cesium sulfate aqueous solution or a phosphoric acid aqueous solution.

35. The pattern formation method of Claim 27,
wherein said exposing light is KrF excimer laser, Xe₂ laser, ArF excimer laser, F₂ laser, KrAr laser or Ar₂ laser.

36. A pattern formation method comprising the steps of:
forming a resist film on a substrate;
forming a barrier film on said resist film;
forming a waterproof film having a waterproof property on said barrier film;
performing pattern exposure by selectively irradiating said resist film through said waterproof film and said barrier film with exposing light with a liquid provided on said waterproof film;
removing said waterproof film; and
removing said barrier film and forming a resist pattern made of said resist film by developing said resist film after removing said waterproof film and after the pattern exposure.

37. The pattern formation method of Claim 36,
wherein said waterproof film includes polyamide.

38. The pattern formation method of Claim 37,
wherein said polyamide is a condensation polymer of ε-caprolactam, a co-condensation polymer of hexamethylene diamine and adipic acid or a co-condensation polymer of p-phenylene diamine and terephthalic acid.

39. The pattern formation method of Claim 36, further comprising, between the step of forming a barrier film and the step of performing pattern exposure, a step of annealing said barrier film.

40. The pattern formation method of Claim 36,
wherein said liquid is water.

41. The pattern formation method of Claim 36,
wherein said liquid is an acidic solution.

42. The pattern formation method of Claim 41,
wherein said acidic solution is a cesium sulfate aqueous solution or a phosphoric acid aqueous solution.

43. The pattern formation method of Claim 36,
wherein said exposing light is KrF excimer laser, Xe₂ laser, ArF excimer laser, F₂ laser, KrAr laser or Ar₂ laser.

44. A pattern formation method comprising the steps of:
forming a resist film on a substrate;
forming a barrier film on said resist film;
forming a waterproof film having a waterproof property on said barrier film;
performing pattern exposure by selectively irradiating said resist film through said waterproof film and said barrier film with exposing light with a liquid provided on said waterproof film;
removing said waterproof film;
removing said barrier film; and
forming a resist pattern made of said resist film by developing said resist film after removing said barrier film and after the pattern exposure.

45. The pattern formation method of Claim 44,
wherein said waterproof film includes polyamide.

46. The pattern formation method of Claim 45,
wherein said polyamide is a condensation polymer of ε-caprolactam, a co-condensation polymer of hexamethylene diamine and adipic acid or a co-condensation polymer of p-phenylene diamine and terephthalic acid.

47. The pattern formation method of Claim 44, further comprising, between the step of forming a barrier film and the step of performing pattern exposure, a step of annealing said barrier film.

48. The pattern formation method of Claim 44,
wherein said liquid is water.

49. The pattern formation method of Claim 44,
wherein said liquid is an acidic solution.

50. The pattern formation method of Claim 49,
wherein said acidic solution is a cesium sulfate aqueous solution or a phosphoric acid aqueous solution.

51. The pattern formation method of Claim 44,
wherein said exposing light is KrF excimer laser, Xe₂ laser, ArF excimer laser, F₂ laser, KrAr laser or Ar₂ laser.
